(19) Europäisches Patentamt / European Patent Office / Office européen des brevets

(11) **EP 2 486 603 B1**

(12) **FASCICULE DE BREVET EUROPEEN**

(45) Date de publication et mention de la délivrance du brevet:
**15.08.2018 Bulletin 2018/33**

(21) Numéro de dépôt: **10778700.4**

(22) Date de dépôt: **06.10.2010**

(51) Int Cl.:
*H01L 31/18* *(2006.01)*   *H01L 31/032* *(2006.01)*

(86) Numéro de dépôt international:
**PCT/FR2010/052105**

(87) Numéro de publication internationale:
**WO 2011/042660 (14.04.2011 Gazette 2011/15)**

(54) **FABRICATION DE COUCHES MINCES À PROPRIÉTÉS PHOTOVOLTAÏQUES, À BASE D'UN ALLIAGE DE TYPE I-III-VI2, PAR ÉLECTRO-DÉPÔTS SUCCESSIFS ET POST-TRAITEMENT THERMIQUE**

HERSTELLUNG VON DÜNNSCHICHTEN MIT PHOTOVOLTAISCHEN EIGENSCHAFTEN UND MIT LEGIERUNG VOM A I-III-VI2-TYP SOWIE MIT FORTLAUFENDEN ELEKTRODEPONIERUNGEN UND THERMISCHE NACHBEHANDLUNG

PRODUCTION OF THIN FILMS HAVING PHOTOVOLTAIC PROPERTIES AND CONTAINING A I-III-VI2-TYPE ALLOY, COMPRISING SUCCESSIVE ELECTRODEPOSITS AND THERMAL POST-TREATMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.10.2009 FR 0956996**

(43) Date de publication de la demande:
**15.08.2012 Bulletin 2012/33**

(73) Titulaire: **Nexcis**
**13106 Rousset (FR)**

(72) Inventeurs:
• **GRAND, Pierre-Philippe**
  **F-13790 Rousset (FR)**
• **JAIME, Salvador**
  **F-13790 Rousset (FR)**
• **BROUSSILLOU, Cédric**
  **F-13790 Rousset (FR)**

(74) Mandataire: **Cabinet Plasseraud**
**66, rue de la Chaussée d'Antin**
**75440 Paris Cedex 09 (FR)**

(56) Documents cités:
**US-A1- 2007 089 782    US-A1- 2007 093 006**

**Description**

Arrière-plan technique et problème posé

La présente invention traite de la fabrication de cellules photovoltaïques notamment pour la conversion de l'énergie solaire en électricité. Plus particulièrement, de telles cellules présentent souvent une structure selon un empilement de couches minces et l'une au moins de ces couches minces possède des propriétés photovoltaïques. La présente invention porte en particulier sur la préparation et l'obtention de cette couche photovoltaïque, dite « absorbeur » par la suite.

L'absorbeur est préparé ici par électro-dépôt. Il est à base d'un alliage formé des éléments des colonnes I (tel le cuivre), III (tel l'indium et/ou le gallium et/ou l'aluminium) et VI (tel le soufre et/ou le sélénium). Un tel alliage, de stoechiométrie globale voisine de I-III-VI$_2$, est connu pour offrir de bonnes propriétés photovoltaïques.

Dans la technique de la présente demande, on forme d'abord un alliage solide I-III par électro-dépôt et l'élément VI est apporté ensuite par recuit en atmosphère riche en élément VI. En pratique, deux électrodes auxquelles on applique une différence de potentiel (en volts) sont plongées dans un bain d'électrolyse contenant des sels adéquats (par exemple de composés à base de cuivre, ou d'indium ou de gallium, comme on le verra plus loin) et le dépôt se forme sur l'une des électrodes.

Toutefois, il advient souvent que l'alliage I-III présente localement des inhomogénéités de composition par rapport au dépôt global, ainsi que des irrégularités de forme (cavités, irrégularités d'interface ou autres). De plus, ces défauts restent présents dans la couche finale après apport de l'élément VI et le rendement de conversion photovoltaïque en est affecté.

La présente invention vient améliorer la situation. Les documents US2007/0093006 et US2007/0089782 décrivent la formation d'une couche CIGS ou CIS par empilement de couches d'éléments I et d'éléments III.

Présentation de l'invention

Elle propose à cet effet de créer une structure multicouche comportant au moins un empilement de couches élémentaires de type I/III/I/III et d'appliquer un recuit à cette structure avant l'apport d'élément VI.

La présente invention vise alors un procédé de fabrication d'une couche mince à propriétés photovoltaïques, notamment pour une application dans une cellule solaire, à base d'un alliage de type I-III-VI$_2$ et déposée par électrolyse, le procédé comportant au moins les étapes :

a) de dépôts successifs de couches d'éléments métalliques I et III,

b) et de post-traitement thermique avec apport d'élément VI.

Au sens de l'invention, l'étape a) comporte en particulier les opérations :

a1) déposer une structure multicouche comportant au moins :

- deux couches d'élément I et

- deux couches d'élément III

déposées en alternance (selon donc un empilement de couches élémentaires de type I/III/I/III ou III/I/III/I), et

a2) appliquer un recuit à cette structure avant l'apport d'élément VI pour obtenir un alliage I-III.

Il a été en effet observé que, de façon particulièrement avantageuse, une structure multicouche d'au moins deux alternances I/III (ou III/I) conservait de bonnes propriétés d'adhésion sans nécessiter de recuit intermédiaire.

En particulier, l'épaisseur totale de la structure multicouche peut être choisie en vue de limiter les phénomènes de décohésion liés aux différences de comportement mécaniques des couches successives. Selon les essais réalisés, l'épaisseur totale de la structure finale peut être comprise par exemple entre 1 et 3 $\mu$m, après apport d'élément VI.

Il a été observé qu'un facteur favorable à la cohésion de la structure multicouche, sans nécessiter de recuit, pouvait être lié à des conditions de dépôt différentes des couches d'un même élément dans la structure multicouche. Ainsi, le procédé au sens de l'invention comporte préférentiellement des conditions de dépôt distinctes pour au moins deux couches d'un même élément. En particulier, il est avantageux que la deuxième couche d'élément I soit déposée à un potentiel d'électrode supérieur, en valeur absolue, au potentiel de dépôt de la première couche d'élément I. Dans des exemples de réalisation proposés ci-après, pour du cuivre en tant qu'élément I, le potentiel de dépôt de la première couche déposée (près du substrat) est de -1V par rapport à une électrode de référence, tandis que la deuxième couche d'élément cuivre peut être déposée à un potentiel de -1,3V.

Les épaisseurs respectives des couches déposées à l'opération a1), quant à elles, peuvent être fonctions d'une proportion choisie entre les éléments I et III dans l'alliage I-III.

Pour ce qui concerne les proportions préférées entre l'élément I et l'élément III dans l'alliage I-III de l'opération a2), si la couche mince à obtenir est à base d'un alliage de type CuIn(S,Se)$_2$, la structure multicouche de l'opération a1) comporte préférentiellement un ratio atomique Cu/In compris entre 1,2 et 2,0.

Si la couche mince à obtenir est à base d'un alliage de type Cu(In,Ga)(S,Se)$_2$, la structure multicouche de l'opération a1) comporte préférentiellement :

- un ratio atomique Cu/(In+Ga) compris entre 0,8 et 1,0 et
- un ratio atomique Ga/(In+Ga) compris entre 0,1 et 0,4.

Une structure multicouche avantageuse est telle que l'une au moins des couches d'élément III de la structure comporte au moins deux sous-couches d'éléments III distincts. Par exemple, une structure multicouche possible peut être de type Cu/In/Ga/Cu/In/Ga.

Il est rappelé ici que le ratio atomique entre deux éléments A et B, noté a/b, se déduit des épaisseurs respectives des couches d'élément A et d'élément B, comme suit :

$$a/b = \frac{\left(\dfrac{DA.EA}{RA}\right)}{\left(\dfrac{DB.EB}{RB}\right)},$$

où :

- EA et EB sont les épaisseurs des couches respectivement de l'élément A et de l'élément B,

- DA et DB sont leurs densités respectives, et

- RA et RB sont leurs masses molaires respectives.

Néanmoins, les épaisseurs relatives des couches d'éléments I et III dans la structure multicouche de l'opération a1) peuvent être choisies en outre en fonction des conditions de traitement thermique et/ou d'apport d'élément VI. Par exemple, si le traitement thermique intervient à une température supérieure à 156°C, correspondant à la température de fusion de l'indium en tant qu'élément III, une fuite d'indium peut intervenir. Il est toutefois possible de compenser cette fuite d'indium en prévoyant des couches d'indium plus épaisses, en apportant ainsi plus d'indium à la stoechiométrie globale de la structure multicouche, ce qui permet d'opérer par exemple un traitement thermique accéléré à une température supérieure à 156°C.

Les épaisseurs relatives des couches d'éléments I et III dans la structure multicouche peuvent être choisies encore en fonction d'un degré d'inter-miction souhaité entre les éléments I et III dans l'alliage I-III de l'opération a2). Typiquement, plus les couches de la structure multicouche sont fines et plus le degré d'inter-miction atteint est élevé. Bien entendu, ce degré d'inter-miction dépend encore des conditions de traitement thermique pour obtenir l'alliage I-III, mais aussi pour obtenir l'alliage ternaire final I-III-VI$_2$ (après apport d'élément VI). Des caractéristiques préférées de traitements thermiques sont données à titre d'exemple ci-après.

L'opération a2) comporte préférentiellement une élévation à une température d'alliage comprise entre 100 et 250°C pendant une durée comprise entre 5 et 120 minutes. Elle peut être suivie d'un retour à température ambiante en un temps compris entre 20 et 180 secondes afin de tremper l'alliage I-III avant l'apport d'élément VI. En variante, l'alliage I-III est maintenu à température d'alliage avant l'apport en élément VI.

L'apport d'élément VI peut comporter aussi un deuxième traitement thermique, préférentiellement en atmosphère d'élément VI avec une montée en température jusqu'à une température comprise entre 450 et 600°C, puis le maintien à cette température pendant une durée comprise entre 30 et 600 secondes. La vitesse de montée en température peut être comprise entre 3,5°C/s et 20 °C/s. Ce type de traitement thermique est particulièrement favorable à l'apport de soufre en tant qu'élément VI dans la couche mince à base de l'alliage ternaire I-III-VI$_2$. Dans une telle réalisation, le soufre est apporté dans un mélange d'argon et/ou d'azote et de vapeur de soufre, à une pression contrôlée entre 10 et 1200 mbar.

Dans une variante, l'apport en élément VI peut comporter :

- une condensation de vapeurs comportant l'élément VI à une température de l'alliage I-III inférieure à 100°C,

- suivie d'une augmentation de température entre 150 et 250°C pendant 30 secondes à 15 minutes,

- suivie d'une élévation en température jusqu'à 450 à 550°C pendant 30 secondes à 15 minutes.

Ce type de traitement est particulièrement adapté pour l'apport de sélénium en tant qu'élément VI. Bien que ce traitement d'apport en élément VI soit avantageux dans le cas d'une structure multicouche au sens de l'invention, il pourrait être approprié aussi à tout autre type de couche mince initiale (par exemple une structure initiale I/III ou III/I, avant recuit, ou encore une couche initiale d'alliage I-III directement électro-déposé). Ainsi, ce traitement peut faire l'objet d'une protection séparée, indépendante du type de couches (I, III) préalablement électro-déposées. Bien entendu, ce traitement peut se poursuivre par une sulfuration selon le deuxième traitement thermique décrit ci-avant pour obtenir un alliage ternaire I-III-(S,Se)$_2$ incluant à la fois du sélénium et du soufre en tant qu'élément VI.

Il peut être avantageux que la structure multicouche commence par une couche d'élément I (tel le cuivre), en contact avec un substrat (souvent en molybdène) ou en contact avec une couche d'adaptation (de ruthénium par exemple comme décrit plus loin), sur lequel ou laquelle est déposée la structure multicouche. Par ailleurs, il s'est avéré particulièrement avantageux que la structure multicouche se termine, en surface, par une couche d'élément I, tel du cuivre, pour limiter une évaporation possible de l'élément III, tel l'indium. Il est également décrit une couche mince à propriétés photovoltaïques, à base d'un alliage de type I-III-VI$_2$ et obtenue par le procédé selon l'invention. En particulier, la couche peut comporter, en épaisseur, une variation alternée de proportion d'alliage en élément I et en élément III. En pratique, on pourra observer par exemple par diffraction de rayons X (DRX) la présence d'élément I non combiné à l'élément III (par exemple du cuivre seul) et la présence par ailleurs d'un alliage I-III (en particulier Cu$_{11}$In$_9$ dans un exemple où le cuivre est l'élément I et l'indium est l'élément III). Comme indiqué ci-avant, il pourra être observé aussi dans la couche finale une légère variation de concentration en élément I et en élément III, même si bien entendu le recuit thermique a vocation à atténuer autant que possible cette variation. Un moyen pour observer une telle variation peut par exemple consister en une mesure par spectroscopie de type SIMS (pour « Secondary Ion Mass Spectroscopy »).

L'invention vise aussi le procédé de fabrication d'une cellule solaire comportant les étapes du procédé au sens de l'invention pour fabriquer une couche mince à propriétés photovoltaïques en tant qu'absorbeur. En effet, le procédé peut se poursuivre ensuite par le dépôt d'un couche de revêtement jouant le rôle de fenêtre optique transparente, puis de couches dopées, etc. La présente invention vise aussi une cellule solaire comportant une couche active au sens de l'invention.

### Avantages de l'invention

L'avantage du dépôt d'une succession de couches élémentaires de type I/III/I/III, suivi d'un recuit à température judicieuse, se manifeste par une meilleure intermiction (ou « inter-diffusion ») des éléments I et III avant l'apport d'élément VI (par sulfuration et/ou sélénisation, comme on le verra plus loin). Compte tenu de la longueur de diffusion de l'élément III et/ou de l'élément I (tel l'indium, le cuivre et/ou le gallium), on choisit de façon optimale la température de recuit en fonction des épaisseurs des couches élémentaires.

Par ailleurs, la mise en oeuvre d'une telle réalisation permet de contrôler un effet mécanique. En effet, le fait d'empiler des couches fines permet de redistribuer les contraintes dans ces couches afin de diminuer un moment de force de décollement et donc d'améliorer la tenue des couches sur le substrat lors du traitement thermique.

On comprendra ainsi que les épaisseurs des couches, ainsi que la durée et la température du recuit, avant l'apport de l'élément VI, sont optimisées ici pour obtenir des résultats qui se sont avérés très satisfaisants, comme décrit ci-après dans des exemples de réalisation.

De façon avantageuse, l'empilement I/III/I/III ne se fait qu'en une passe dans un bain d'électrolyse et le recuit et l'apport en élément VI peuvent aussi ne se faire qu'en une passe dans un four ou une étuve appropriés. Ainsi, il n'est pas nécessaire, au sens de l'invention, de prévoir de recuits intermédiaires d'empilements I/III, c'est-à-dire de :

- déposer par électrolyse un empilement I/III,
- recuire cet empilement I/III,
- introduire à nouveau cet empilement I/III dans un bain d'électrolyse pour redéposer par-dessus un nouvel empilement I/III,
- recuire à nouveau l'empilement global I/III/I/III,
- éventuellement, répéter encore ces étapes,
- et effectuer une sélénisation ou une sulfuration d'un empilement global I/III obtenu.

Il convient d'indiquer toutefois qu'une telle réalisation est possible techniquement, car l'alliage I-III, comme les couches élémentaires I et III, sont métalliques, donc conductrices, donc adaptées pour recevoir un dépôt par électrolyse qui les revêt.

### Brève présentation des dessins

D'autres caractéristiques et avantages de l'invention apparaîtront à l'examen de la description détaillée ci-après, et des dessins annexés, à l'échelle, sur lesquels :

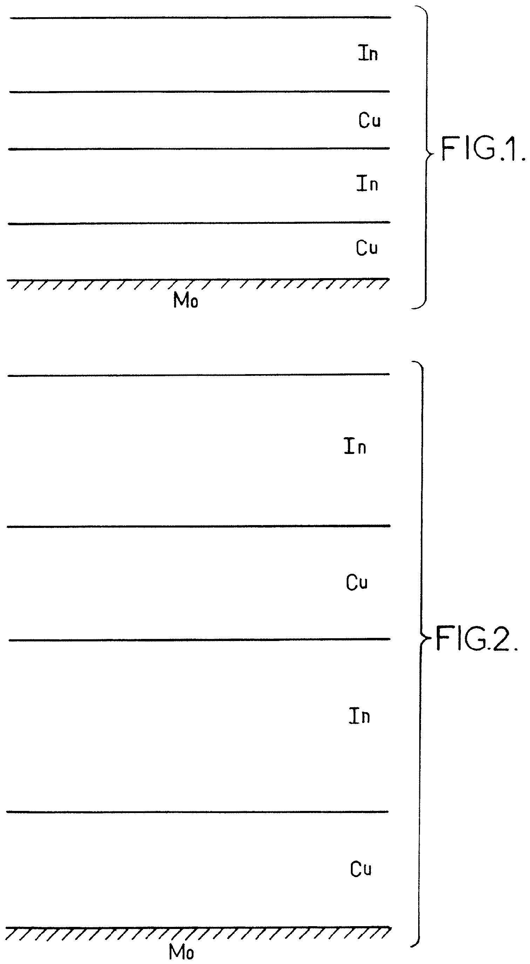

- la figure 1 représente schématiquement un empilement selon une structure multicouche I/III/I/III selon un premier mode de réalisation où les couches d'élément I sont de 150 nm d'épaisseur et comportent du cuivre et les couches d'élément III sont de 200 nm d'épaisseur et comportent de l'indium, pour atteindre une épaisseur totale de 700 nm,
- la figure 2 représente schématiquement un empilement selon une structure multicouche I/III/I/III selon un deuxième mode de réalisation où les couches d'élément I sont de 300 nm d'épaisseur et comportent du cuivre et les couches d'élément III sont de 400 nm d'épaisseur et comportent de l'indium, pour atteindre une épaisseur totale de 1400 nm,

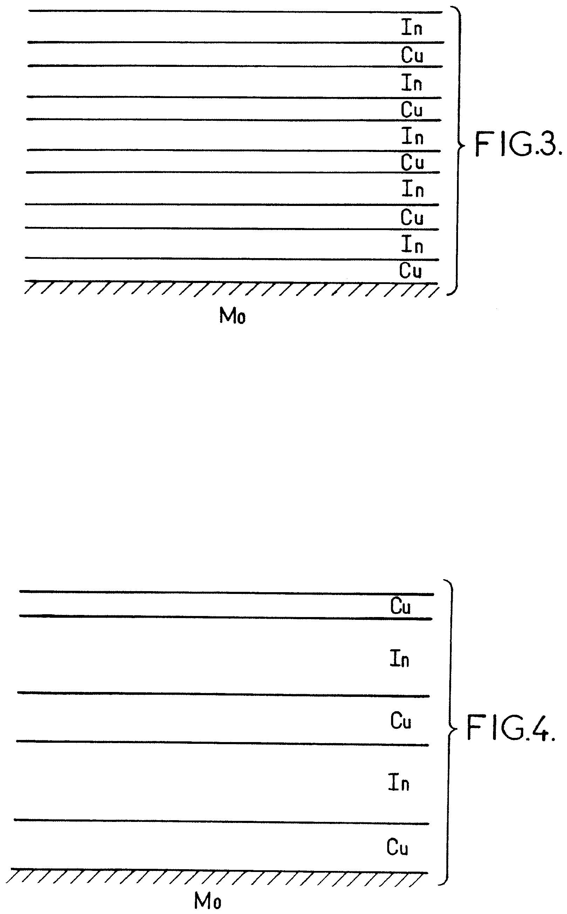

- la figure 3 représente schématiquement un empilement selon une structure multicouche I/III/I/III/I/III/I/III/I/III selon un troisième mode de réalisation où les couches d'élément I sont de 60 nm d'épaisseur et comportent du cuivre et les couches d'élément III sont de 80 nm d'épaisseur et comportent de l'indium, pour atteindre une épaisseur totale de 700 nm,
- la figure 4 représente schématiquement un empilement correspondant à celui illustré sur la figure 1 mais dans lequel les couches de cuivre ont une épaisseur de 120 nm et comportant en outre une cinquième couche, de cuivre, recouvrant l'empilement et d'épaisseur de 60 nm, selon un quatrième mode de réalisation,

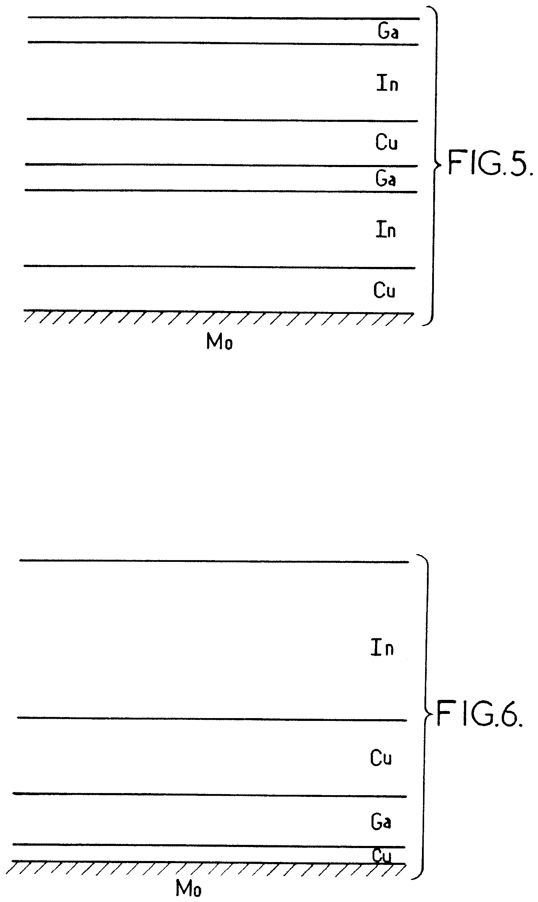

- la figure 5 représente schématiquement un empilement I/III/I/III selon un cinquième mode de réalisation, de type Cu (115 nm d'épaisseur), In (200 nm d'épaisseur), Ga (65 nm d'épaisseur), Cu (115 nm d'épaisseur), In (200 nm d'épaisseur), Ga (65 nm d'épaisseur), et

-   la figure 6 représente schématiquement un empilement I/III/I/III selon un sixième mode de réalisation, de type Cu (40 nm d'épaisseur), Ga (130 nm d'épaisseur), Cu (190 nm d'épaisseur), In (400 nm d'épaisseur).

Description de modes de réalisation

On décrit de façon plus détaillée la fabrication de cellules solaires dont l'absorbeur est synthétisé par :

-   Electro-dépôt (ED) séquentiel en multicouches ici de cuivre (Cu), d'indium (In) et éventuellement de gallium (Ga) puis
-   Transformation en semi-conducteur de type p par apport d'élément VI (sulfuration ou sélénisation) lors d'un traitement thermique.

La réalisation de cellules à base d'un tel empilement pour former l'alliage $CuInS_2$ (CIS) ou $CuInGaSe_2$ (CIGSe) selon ce procédé a permis d'obtenir des rendements de conversion photovoltaïque supérieurs à 8%. Ces dépôts séquentiels en multicouche favorisent l'inter-diffusion des éléments Cu-In, Cu-Ga et/ou Cu-In-Ga.
Pour la fabrication de la cellule complète, on procède souvent ainsi :

-   on dépose, sur un substrat de verre sodocalcique (d'épaisseur 1-3mm ou un feuillet de métal préférentiellement en inox 430 et d'épaisseur : 50-500$\mu$m) une couche de molybdène Mo par pulvérisation cathodique (ou « sputtering »), d'épaisseur 400-1000 nm, et préférentiellement 500 nm (résistance carrée comprise entre 0,1-0,4 $\Omega$),
-   dans le cas d'un feuillet métallique, une couche barrière d'oxyde ($SiO_x$, $Al_2O_3$, $AlSiO_x$, verre fritté) ou de chrome Cr, d'épaisseur : 20-3000 nm selon le matériau utilisé, est ajoutée ;
-   éventuellement, on dépose en outre une couche de ruthénium, tantale par sputtering (épaisseur 2-20 nm) afin d'améliorer les propriétés d'adhésion de la future couche de cuivre sur le molybdène ;
-   on dépose ensuite l'alliage métallique Cu-In ou Cu-In-Ga, comme on le verra plus loin, par électro-dépôts successifs de couches de Cu, In (et éventuellement Ga). Cette étape permet également l'incorporation d'une certaine quantité de sodium dans la couche ;
-   puis éventuellement, pour ajuster le taux de sodium dans l'absorbeur, on dépose par évaporation ou par sputtering une couche de NaF (épaisseur : 5-150 nm), et
-   on procède au traitement thermique pour former l'alliage ad hoc, suivi d'un autre recuit sous atmosphère de soufre et/ou de sélénium pour l'apport d'élément VI.

Les couches formées par électro-dépôt de Cu et In doivent permettre d'obtenir un ratio atomique Cu/In compris entre 1,2 et 2,0, préférentiellement 1,65. Les couches formées par électro-dépôt de Cu, d'In et de Ga doivent permettre d'obtenir un ratio atomique Cu/(In+Ga) compris entre 0,8 et 1,0, préférentiellement 0,9 et Ga/(In+Ga) compris entre 0,1 et 0,4, préférentiellement 0,3.
On a représenté sur les figures 1 à 6 (à l'échelle relative) les épaisseurs optimales de couches élémentaires de l'empilement de chacun des six modes de réalisation décrits ci-après.
Après les dépôts successifs en multicouche de Cu et d'In (et éventuellement Ga), pour permettre la formation du composé CIS (CISe ou CIGSe ou CIGS ou CIGSSe), de structure cristalline chalcopyrite, un traitement thermique en au moins deux temps est utilisé. Si les couches déposées par électrolyse sont Cu et In, la première partie du traitement thermique permet de former à partir du cuivre métallique et de l'alliage métastable $CuIn_2$, l'alliage $Cu_{11}In_9$. Si les couches déposées par électrolyse sont Cu, In et Ga, la première partie du traitement thermique permet de former l'alliage $Cu_xIn_yGa_z$ (avec x, y et z tels que la proportion d'alliage varie de $Cu_{11}In_9$ à $CuGa_2$). La première partie du traitement thermique est réalisée à pression contrôlée, sous atmosphère inerte d'azote ou d'argon pour empêcher l'oxydation des couches métalliques de cuivre et d'indium. Une fois le traitement thermique d'alliage terminé, l'empilement peut être :

-   ramené à température ambiante en un temps compris entre 20 et 180 secondes (préférentiellement entre 20 et 60 secondes, par exemple 45 secondes) afin de tremper l'alliage $Cu_nIn_9$ ou $Cu_xIn_yGa_z$ et conserver cette structure pour l'étape suivante,
-   ou être maintenu à la température d'alliage et être transféré dans la chambre de sulfuration.

Cet alliage est ensuite soumis à une deuxième étape de traitement thermique sous atmosphère soufrée ou sélénisée pour permettre la réaction et la formation de la structure chalcopyrite CIS, CISe, CIGSe, CIGS ou CIGSSe. Le soufre ou le sélénium peut être introduit (avant ou pendant le traitement thermique) sous forme solide S ou Se (poudre, pastille, CBD sur l'échantillon), liquide par spray ou gazeuse ($H_2S$, $H_2Se$, soufre ou sélénium élémentaire vaporisé).
Ces deux étapes peuvent être réalisées séparément en revenant à la température ambiante entre temps ou séquentiellement afin d'optimiser le rendement énergétique du recuit.
Après décapage chimique dans un bain de KCN (0,1-2,5M), une couche de CdS (épaisseur 30-100nm, préférentiellement 50nm) ou ZnS (épaisseur 10-50nm, préférentiellement 20nm) est déposée par voie chimique. Si cette couche précédente est CdS, une couche de iZnO (épaisseur 30-150nm, préférentiellement 80nm) est déposée par sputtering. Si la couche précédente est ZnS, une couche de ZnMgO (épaisseur 30-150nm, préférentiellement 90nm) est déposée par sputtering. Enfin, une couche de ZnO dopé Al (épaisseur 300-1500nm, préférentiellement 500nm) est déposée par sputtering. Après discrétisation ou dépôt d'une grille de collecte, on obtient une cellule photovoltaïque dont on peut mesurer alors le rendement de conversion.

**Premier mode de réalisation**

Une couche de CIS peut être formée sur un substrat verre (3mm)/molybdène (500nm) ou inox 430 (127$\mu$m)/SiO$_x$ (1000nm)/molybdène (500nm) par :

- 1- dépôt d'une couche de Cuivre de 150 nm par électrolyse à partir d'un bain dont les concentrations sont les suivantes : CuSO$_4$ (0,075 mol/l) et trisodium citrate (0,250 mol/l ou « M » pour 'mol/l'). Les couches sont déposées par une réaction cathodique à potentiel imposé, à -1,1 Volt (V) par rapport à l'électrode de référence (au sulfate mercureux). La densité de courant est de -1,5m-A.cm$^{-2}$ La température de bain est de 20-25°C (température ambiante) et le bain est agité.

- 2- dépôt d'une couche d'Indium de 200 nm par électrolyse à partir d'un bain dont les concentrations sont les suivantes : In$_2$(SO$_4$)$_3$ (0,044 M) et sodium sulfate (0,493 M). Les couches sont déposées par une réaction cathodique à intensité imposée, à -0.5 mA.cm$^{-2}$. Le potentiel de dépôt est alors compris entre -1,05 et -1,09 V/MSE. La température de bain est de 20-25°C (température ambiante) et le bain est agité.

- 3- répétition de l'opération 1- en modifiant le potentiel imposé à -1,3V. La densité de courant est de -2,5mA.cm$^{-2}$.

- 4- répétition de l'opération 2- Le rapport atomique Cu/In est alors voisin de 1,65, avec un léger excès de cuivre par rapport à ce rapport.

La figure 1 illustre schématiquement l'empilement obtenu avant traitement thermique.

- 5- un traitement thermique ayant pour but la formation du composé Cu$_{11}$In$_9$ est réalisé à une température comprise entre 100 et 250°C, préférentiellement entre 120°C et 200°C (par exemple 155°C), pendant une durée comprise entre 5 et 120 min (par exemple 30 min) selon le degré d'inter-diffusion souhaité. Ce traitement thermique est réalisé à pression contrôlée, sous atmosphère inerte d'azote ou d'argon pour empêcher l'oxydation des couches métalliques de cuivre et d'indium. Une fois le traitement thermique d'alliage terminé, l'empilement est ramené à la température ambiante en un temps compris entre 20 et 180s préférentiellement entre 20 et 60s (par exemple 45s) afin de tremper l'alliage Cu$_{11}$In$_9$ et conserver cette structure pour l'étape suivante.

- 6- La deuxième étape de recuit consiste en la montée en température du mélange entre l'alliage Cu$_{11}$In$_9$ et le cuivre métallique en surplus jusqu'à une température maximale comprise entre 450 et 600°C (par exemple 500°C) puis le maintien à cette température pendant une durée comprise entre 30 et 600 secondes, préférentiellement entre 90 et 180s (par exemple 120s). La vitesse de montée en température est comprise entre 3,5 °C/s et 20 °C/s, plus préférentiellement entre 7 °C/s et 12 °C/s (par exemple 8°C/s). Ce traitement est réalisé sous atmosphère soufrée d'un mélange d'argon ou d'azote et de vapeur de soufre, à une pression contrôlée qui peut être choisie entre 10 et 1200 mbar (par exemple 1100 mbar). Le soufre est introduit préalablement à la montée en température dans la chambre à proximité de l'échantillon sous forme de poudre. La quantité de soufre utilisée est entre 1 et 10 fois la stoechiométrie. Une fois le traitement à haute température terminé, l'absorbeur est ramené à température ambiante mais doit être conservé sous atmosphère inerte jusqu'à une température inférieure à 150°C. Après sulfuration, le matériau est composé d'une couche de CuInS$_2$ de structure chalcopyrite et d'une couche surfacique non continue de binaires Cu$_x$S$_y$

- 7-Décapage chimique dans un bain de KCN (1M) à 25°C pendant 5 min,

- 8- Formation d'une couche de CdS 50nm par dépôt par bain chimique à T$_f$= 65°C à partir d'un bain comprenant : [Cd(Ac)$_2$] = 1,4.10$^{-3}$ M, [SC(NH$_2$)$_2$] = 0,28 M et [NH$_3$] = 1,5 M

- 9- Formation d'une couche de iZnO d'épaisseur 80nm puis d'une couche de ZnO dopé Al d'épaisseur 500nm par sputtering.

**Deuxième mode de réalisation**

Une couche de CIS peut être formée sur un substrat verre (3mm)/molybdène (500nm) ou inox 430 (127$\mu$m)/SiO$_x$ (1000nm)/molybdène (500nm) par :

- 1- dépôt d'une couche de cuivre de 300 nm par électrolyse à partir d'un bain dont les concentrations sont les suivantes : C$_u$SO$_4$ (0,075 M) et trisodium citrate (0,250 M). Les films sont déposés par une réaction cathodique à potentiel imposé, à -1,1V par rapport à l'électrode de référence (au sulfate mercureux). La densité de courant est de -1,5mA.cm$^{-2}$.

- 2- dépôt d'une couche d'Indium de 400 nm par électrolyse à partir d'un bain dont les concentrations sont les suivantes : In$_2$(SO$_4$)$_3$ (0,044 M) et sodium sulfate (0,493 M). Les films sont déposés par une réaction cathodique à intensité imposée, à -0.5 mA.cm$^{-2}$. Le

potentiel de dépôt est alors E ≈ [-1.05 ;-1.09] V/MSE.

- 3- répétition de l'opération 1- en modifiant le potentiel imposé à -1,3V. La densité de courant est de -2,5mA.cm$^{-2}$.

- 4- répétition de l'opération 2- Le rapport atomique Cu/In est alors de 1,65.

La figure 2 illustre schématiquement l'empilement obtenu avant traitement thermique.

- 5- répétition des opérations 5- à 9- du premier mode de réalisation

**Troisième mode de réalisation**

Une couche de CIS peut être formée sur un substrat verre (3mm)/molybdène (500nm) ou inox 430 (127μm)/SiO$_x$ (1000nm)/molybdène (500nm) par :

- 1- dépôt d'une couche de Cuivre de 60 nm par électrolyse à partir d'un bain dont les concentrations sont les suivantes : CuSO$_4$ (0,075 M) et trisodium citrate (0,250 M). Les films sont déposés par une réaction cathodique à potentiel imposé, à -1,1V par rapport à l'électrode de référence (au sulfate mercureux). La densité de courant est de -1,5mA.cm$^{-2}$.

- 2- dépôt d'une couche d'Indium de 80 nm par électrolyse à partir d'un bain dont les concentrations sont les suivantes : In$_2$(SO$_4$)$_3$ (0,044 M) et sodium sulfate (0,493 M). Les films sont déposés par une réaction cathodique à intensité imposée, à -0.5 mA.cm$^{-2}$. Le potentiel de dépôt est alors E ≈ [-1.05;-1.09] V/MSE.

- 3- répétition de l'opération 1- en modifiant le potentiel imposé à -1,3V. La densité de courant est de -2,5mA.cm$^{-2}$.

- 4- répétition de l'opération 2-

- 5- répétition des opérations 3- et 4- jusqu'à obtenir une épaisseur total de Cu de 300nm et d'In de 400nm.

La figure 3 illustre schématiquement l'empilement obtenu avant traitement thermique.

- 6- répétition des opérations 5- à 9- du premier mode de réalisation

**Quatrième mode de réalisation**

Une couche de CIS peut être formée sur un substrat verre (3mm)/molybdène (500nm) ou inox 430 (127μm)/SiO$_x$ (1000nm)/molybdène (500nm) par :

- 1- dépôt d'une couche de Cuivre de 120 nm par électrolyse à partir d'un bain dont les concentrations sont les suivantes : CuSO$_4$ (0,075 M) et trisodium citrate (0,250 M). Les précurseurs sont déposés par une réaction cathodique à potentiel imposé, à -1,1V par rapport à l'électrode de référence (au sulfate mercureux). La densité de courant est de -1,5mA.cm$^{-2}$.

- 2- dépôt d'une couche d'Indium de 200 nm par électrolyse à partir d'un bain dont les concentrations sont les suivantes : In$_2$(SO$_4$)$_3$ (0,044 M) et sodium sulfate (0,493 M). Les précurseurs sont déposés par une réaction cathodique à intensité imposée, à -0,5 mA.cm$^{-2}$. Le potentiel de dépôt est alors E ≈ [-1.05;-1.09] V/MSE. Le rapport atomique Cu/In est alors de 1,65.

- 3- répétition de l'opération 1- en modifiant le potentiel imposé à -1,3V. La densité de courant est de -2,5mA.cm$^{-2}$.

- 4- répétition de l'opération 2-

- 5- répétition de l'opération 3- jusqu'à obtention d'une épaisseur de Cu de 60nm. Cette couche superficielle de Cu à pour but d'éviter l'évaporation d'In$_x$S$_y$ durant le traitement thermique de sulfuration, limiter la rugosité de l'alliage avant sulfuration et améliorer la couverture de binaires Cu$_x$S en surface du CIS.

La figure 4 illustre schématiquement l'empilement obtenu avant traitement thermique.

- 6- répétition des opérations 5- à 9- du premier mode de réalisation.

**Cinquième mode de réalisation**

Une couche de CIG(S)Se peut être formée sur un substrat verre (3mm)/molybdène (500nm) ou inox 430 (127μm)/SiO$_x$ (1000nm)/molybdène (500nm) par :

- 1- dépôt d'une couche de Cuivre de 115nm par électrolyse à partir d'un bain dont les concentrations sont les suivantes : CuSO$_4$ (0,075 M) et trisodium citrate (0,250 M). Les précurseurs sont déposés par une réaction cathodique à potentiel imposé, à -1V par rapport à l'électrode de référence (au sulfate mercureux). La densité de courant est de -1mA.cm$^{-2}$.

- 2- dépôt d'une couche d'Indium de 200nm par électrolyse à partir d'un bain dont les concentrations sont les suivantes : In$_2$(SO$_4$)$_3$ (0,044 M) et sodium sulfate (0,493 M). Les précurseurs sont déposés par une réaction cathodique à intensité imposée, à -0,5 mA.cm$^{-2}$. Le potentiel de dépôt est alors E ≈ [-1.05;-1.09] V/MSE.

- 3- dépôt d'une couche de gallium de 65 nm par électrolyse à partir d'un bain dont les concentrations sont les suivantes : Ga$_2$(SO$_4$)$_3$ (0,01 M), HCl (0,002 M) et chlorure de sodium (0,15 M). La température du bain est de 20-25°C. Les films sont déposés par une réaction cathodique à potentiel imposé, à -1,5V par rapport à l'électrode de référence (au sulfate mercureux). La densité de courant est de -2mA.cm$^{-2}$. Une

autre solution de bain pour le dépôt du gallium a donné de bons résultats, avec les bains commercialisés par la société ENTHONE® (référence Heliofab Ga365 RFU). La température du bain est de 60°C et le bain est agité. La densité de courant appliquée est de -40 mA cm$^{-2}$.

- 4- dépôt d'une couche de Cuivre de 115 nm par électrolyse à partir d'un bain dont les concentrations sont les suivantes : $CuSO_4$ (0,075 M) et trisodium citrate (0,250 M). Les précurseurs sont déposés par une réaction cathodique à potentiel imposé, à -1,3V par rapport à l'électrode de référence (au sulfate mercureux). La densité de courant est de -2,5mA.cm$^{-2}$.

- 5- répétition des opérations 2 et 3, une fois, de ce mode de réalisation

- 6- un traitement thermique ayant pour but la formation d'un alliage $Cu_xIn_yGa_z$ est réalisé à une température comprise entre 25 et 200°C, préférentiellement entre 25°C et 100°C pendant une durée comprise entre 1 et 30 min selon le degré d'inter-diffusion souhaité.

La figure 5 illustre schématiquement l'empilement obtenu avant traitement thermique.

- 7- dépôt d'une couche de Sélénium ou condensation des vapeurs de Se sur l'échantillon « froid », c'est-à-dire à température inférieure à 100°C, ou utilisation d'un gaz contenant des vapeurs de sélénium. On augmente la température entre 150 et 250°C en 10°C/s, puis on applique un palier de 30 secondes à 15 minutes. Ensuite, on monte rapidement en température (10°C/s) jusqu'à 450-550°C pour faire croître la taille des grains d'alliage. On maintient le palier entre 30 secondes et 15 minutes. Eventuellement, on procède à une sulfuration avec gaz soufré à température comprise entre 400 et 600°C pendant 30 secondes à 15 minutes pour l'obtention d'un composé penternaire de CuInGaSSe. Enfin, on applique un refroidissement jusqu'à une température inférieure à 100°C et préférentiellement 60°C.

- 8- répétition des opérations 7- à 9- du premier mode de réalisation

**Sixième mode de réalisation**

Une couche de CIG(S)Se peut être formée sur un substrat verre (3mm)/molybdène (500nm) ou inox 430 (127$\mu$m)/SiO$_x$ (1000nm)/molybdène (500nm) par :

- 1- dépôt d'une couche de cuivre de 40nm par électrolyse à partir d'un bain dont les concentrations sont les suivantes : $CuSO_4$ (0,075 M) et trisodium citrate (0,250 M). Les précurseurs sont déposés par une réaction cathodique à potentiel imposé, à -1,1V par rapport à l'électrode de référence (au sulfate mercureux). La densité de courant est de -1,5mA.cm$^{-2}$.

- 2- dépôt d'une couche de gallium de 130nm par électrolyse à partir d'un bain dont les concentrations sont les suivantes : $Ga_2(SO_4)_3$ (0,01 M), HCl (0,002 M) et chlorure de sodium (0,15 M). La température du bain est de 20-25°C. Les films sont déposés par une réaction cathodique à potentiel imposé, à -1,5V par rapport à l'électrode de référence (au sulfate mercureux). La densité de courant est de -2mA.cm$^{-2}$. Le rapport atomique Cu/Ga est alors de 0,5. Les bains de la société ENTHONE® peuvent être utilisés en variante, comme indiqué précédemment.

- 3- dépôt d'une couche de Cuivre de 190 nm par électrolyse à partir d'un bain dont les concentrations sont les suivantes : $CuSO_4$ (0,075 M) et trisodium citrate (0,250 M). Les précurseurs sont déposés par une réaction cathodique à potentiel imposé, à -1,3V par rapport à l'électrode de référence (au sulfate mercureux). La densité de courant est de -2,5mA.cm$^{-2}$.

- 4- dépôt d'une couche d'Indium de 400 nm par électrolyse à partir d'un bain dont les concentrations sont les suivantes : $In_2(SO_4)_3$ (0,044 M) et sodium sulfate (0,493 M). Les précurseurs sont déposés par une réaction cathodique à intensité imposée, à -0,5 mA.cm$^{-2}$. Le potentiel de dépôt est alors E ≈ [-1.05;-1.09] V/MSE. Le rapport atomique Cu/(In+Ga) est alors de 0,9 et Ga/(In+Ga) de 0,3.

La figure 6 illustre schématiquement l'empilement obtenu avant traitement thermique.

- 5- un traitement thermique ayant pour but la formation d'un alliage $Cu_xIn_yGa_z$ est réalisé à une température comprise entre 100 et 250°C, préférentiellement entre 120°C et 200°C (par exemple 155°C), pendant une durée comprise entre 5 et 120 min (par exemple 30 min) selon le degré d'inter-diffusion souhaité.

- 6- application de l'étape 6 du cinquième mode de réalisation.

- 7- répétition des opérations 7- à 9- du premier mode de réalisation.

Ainsi, on comprendra que de multiples exemples de réalisation peuvent être prévus pour obtenir du CIS, CISe, CIGS, CIGSe ou CIGSSe. Un mode de réalisation satisfaisant pour obtenir une couche mince de CIS de 2$\mu$m d'épaisseur consiste à déposer dans les conditions des premier à quatrième modes de réalisation ci-avant : 235 nm de cuivre, 325 nm d'indium, 235 nm de cuivre et 325 nm d'indium, pour parvenir à environ 1120 nm d'empilement Cu/In/Cu/In, puis à effectuer un traitement thermique et un apport d'élément VI (soufre par exemple). On notera que la couche passe d'une épaisseur d'environ 1120 nm avant sulfuration à une épaisseur de 2μm après sulfuration.

**Revendications**

1. Procédé de fabrication d'une couche mince à propriétés photovoltaïques, à base d'un alliage de type I-III-VI$_2$ et déposée par électrolyse, le procédé comportant au moins les étapes :

   a) de dépôts successifs de couches d'éléments métalliques I et III,
   b) et de post-traitement thermique avec apport d'élément VI,

   **caractérisé en ce que** l'étape a) comporte les opérations :

   a1) déposer une structure multicouche comportant au moins :

   - deux couches d'élément I et
   - deux couches d'élément III,

   selon au moins une alternance de couches I/III/I/III ou III/I/III/I, et
   a2) appliquer un recuit à cette structure avant l'apport d'élément VI pour obtenir un alliage I-III.

2. Procédé selon la revendication 1, **caractérisé en ce que** la couche mince à propriété photovoltaïque est à base d'un alliage de type CuIn(S,Se)$_2$, et **en ce que** la structure multicouche de l'opération a1) comporte un ratio atomique Cu/In compris entre 1,2 et 2,0.

3. Procédé selon la revendication 2, **caractérisé en ce que** la couche mince à propriété photovoltaïque est à base d'un alliage de type Cu(In,Ga)(S,Se)$_2$, et **en ce que** la structure multicouche de l'opération a1) comporte :

   - un ratio atomique Cu/(In+Ga) compris entre 0,8 et 1,0 et
   - un ratio atomique Ga/(In+Ga) compris entre 0,1 et 0,4.

4. Procédé selon l'une des revendications précédentes, **caractérisé en ce que** l'épaisseur totale de la structure est comprise entre 1 et 3 μm, après apport d'élément VI.

5. Procédé selon l'une des revendications précédentes, **caractérisé en ce qu'**il comporte des conditions de dépôt distinctes pour au moins deux couches d'un même élément.

6. Procédé selon la revendication 5, **caractérisé en ce que** la deuxième couche d'élément I est déposée à un potentiel d'électrode supérieur, en valeur absolue, à un potentiel de dépôt de la première couche d'élément I.

7. Procédé selon l'une des revendications précédentes, **caractérisé en ce que** l'opération a2) comporte une élévation à une température d'alliage comprise entre 100 et 250°C pendant une durée comprise entre 5 et 120 minutes.

8. Procédé selon la revendication 7, **caractérisé en ce que** l'élévation en température est suivie d'un retour à température ambiante en un temps compris entre 20 et 180 secondes afin de tremper l'alliage I-III avant l'apport d'élément VI.

9. Procédé selon la revendication 7, **caractérisé en ce que** l'alliage I-III est maintenu à température d'alliage avant l'apport en élément VI.

10. Procédé selon l'une des revendications précédentes, **caractérisé en ce que** l'apport d'élément VI comporte un deuxième traitement thermique en atmosphère d'élément VI avec une montée en température jusqu'à une température comprise entre 450 et 600°C, puis le maintien à cette température pendant une durée comprise entre 30 et 600 secondes.

11. Procédé selon l'une des revendications précédentes, **caractérisé en ce que** l'apport en élément VI comporte :

    - une condensation de vapeurs comportant l'élément VI à une température de l'alliage I-III inférieure à 100°C,
    - suivie d'une augmentation de température entre 150 et 250°C pendant un palier de 30 secondes à 15 minutes,
    - suivie d'une élévation en température jusqu'à 450 à 550°C pendant 30 secondes à 15 minutes.

12. Procédé selon la revendication 11, **caractérisé en ce que** l'élément VI comporte du sélénium.

13. Procédé selon l'une des revendications précédentes, **caractérisé en ce que** la structure multicouche se termine, en surface, par une couche d'élément I.

14. Procédé de fabrication d'une cellule solaire, **caractérisé en ce qu'**il comporte le procédé de fabrication d'une couche mince à propriétés photovoltaïques selon l'une des revendications 1 à 13.

**Patentansprüche**

1. Verfahren zur Herstellung einer Dünnschicht mit photovoltaischen Eigenschaften, die auf einer Legierung vom Typ I-III-VI$_2$ basiert und elektrolytisch abgeschieden wird, wobei das Verfahren mindestens folgende Schritte umfasst:

   a) aufeinanderfolgendes Abscheiden von Schichten von I- und III-Metallelementen,
   b) thermisches Nachbehandeln mit Zugabe von VI-Element,

   **dadurch gekennzeichnet, dass** Schritt a) die folgenden Arbeitsgänge umfasst:

   a1) Abscheiden einer Mehrschichtstruktur, die mindestens

   - zwei Schichten von Element I und
   - zwei Schichten von Element III

   umfasst, gemäß mindestens einer Alternanz der Schichten I/III/I/III oder III/I/III/I und
   a2) Tempern dieser Struktur vor der Zugabe von VI-Element zum Erhalt einer I-III-Legierung.

2. Verfahren nach Anspruch 1, **dadurch gekennzeichnet, dass** die Dünnschicht mit photovoltaischen Eigenschaften auf einer Legierung vom Typ CuIn(S,Se)$_2$ basiert und dass die Mehrschichtstruktur des Arbeitsgangs a1) ein Cu/In-Atomverhältnis zwischen 1,2 und 2,0 umfasst.

3. Verfahren nach Anspruch 2, **dadurch gekennzeichnet, dass** die Dünnschicht mit photovoltaischen Eigenschaften auf einer Legierung vom Typ Cu(In,Ga)(S,Se)$_2$ basiert und dass die Mehrschichtstruktur des Arbeitsgangs a1)

   - ein Cu/(In+Ga)-Atomverhältnis zwischen 0,8 und 1,0 und
   - ein Ga/(In+Ga)-Atomverhältnis zwischen 0,1 und 0,4 umfasst.

4. Verfahren nach einem der vorhergehenden Ansprüche, **dadurch gekennzeichnet, dass** die Gesamtdicke der Struktur nach Zugabe von VI-Element zwischen 1 und 3 $\mu$m liegt.

5. Verfahren nach einem der vorhergehenden Ansprüche, **dadurch gekennzeichnet, dass** es Abscheidungsbedingungen umfasst, die für mindestens zwei Schichten des gleichen Elements verschieden sind.

6. Verfahren nach Anspruch 5, wobei die zweite Schicht von I-Element bei einem Elektrodenpotential abgeschieden wird, das als Absolutwert größer ist als ein Abscheidungspotential der ersten Schicht von I-Element.

7. Verfahren nach einem der vorhergehenden Ansprüche, **dadurch gekennzeichnet, dass** der Arbeitsgang a2) eine Erhöhung auf eine Legierungstemperatur zwischen 100 und 250 °C über einen Zeitraum zwischen 5 und 120 Minuten umfasst.

8. Verfahren nach Anspruch 7, **dadurch gekennzeichnet, dass** auf die Temperaturerhöhung eine Rückkehr auf Umgebungstemperatur innerhalb von 20 bis 180 Sekunden zum Abschrecken der I-III-Legierung vor der Zugabe von VI-Element folgt.

9. Verfahren nach Anspruch 7, **dadurch gekennzeichnet, dass** die I-III-Legierung vor der Zugabe von VI-Element bei Legierungstemperatur gehalten wird.

10. Verfahren nach einem der vorhergehenden Ansprüche, **dadurch gekennzeichnet, dass** die Zugabe von VI-Element eine zweite thermische Behandlung in VI-Element-Atmosphäre mit einer Temperaturerhöhung auf eine Temperatur zwischen 450 und 600 °C und ein anschließendes Halten dieser Temperatur über einen Zeitraum zwischen 30 und 600 Sekunden umfasst.

11. Verfahren nach einem der vorhergehenden Ansprüche, **dadurch gekennzeichnet, dass** die Zugabe von VI-Element Folgendes umfasst:

    - Kondensieren von Dämpfen, die das VI-Element enthalten, bei einer I-III-Legierungstemperatur von weniger als 100 °C,
    - gefolgt von einer Temperaturerhöhung zwischen 150 und 250 °C über einen Zeitraum von 30 Sekunden bis 15 Minuten,
    - gefolgt von einer Temperaturerhöhung auf 450 bis 550 °C über einen Zeitraum von 30 Sekunden bis 15 Minuten.

12. Verfahren nach Anspruch 11, **dadurch gekennzeichnet, dass** das VI-Element Selen umfasst.

13. Verfahren nach einem der vorhergehenden Ansprüche, **dadurch gekennzeichnet, dass** die Mehrschichtstruktur an der Oberfläche mit einer Schicht aus I-Element abschließt.

14. Verfahren zur Herstellung einer Solarzelle, **dadurch gekennzeichnet, dass** es das Verfahren zur Herstellung einer Dünnschicht mit photovoltaischen Eigenschaften nach einem der Ansprüche 1 bis 13 umfasst.

**Claims**

1. Method for producing a thin film with photovoltaic properties, based on a I-III-VI$_2$ alloy and deposited by electrolysis, said method comprising at least the steps of:

   a) successively depositing layers of metal elements I and III,
   b) and applying thermal post-treatment with the addition of element VI,

   wherein step a) comprises the following operations:

   a1) depositing a multilayer structure comprising at least:

   - two layers of element I and
   - two layers of element III,

   in at least one alternating sequence of the layers I/III/I/III or III/I/III/I, and
   a2) annealing this structure before adding element VI to obtain a I-III alloy.

2. Method according to claim 1, wherein the thin film with photovoltaic properties is based on a CuIn(S,Se)$_2$ alloy, and wherein the multilayer structure of operation a1) comprises an atomic ratio for the Cu/In of between 1.2 and 2.0.

3. Method according to claim 2, wherein the thin film with photovoltaic properties is based on a Cu(In,Ga)(S,Se)$_2$ alloy, and wherein the multilayer structure of operation a1) comprises:

   - an atomic ratio for the Cu/(In+Ga) of between 0.8 and 1.0, and
   - an atomic ratio for the Ga/(In+Ga) of between 0.1 and 0.4.

4. Method according to any one of the above claims, wherein the total thickness of the structure is between 1 and 3 $\mu$m, after element VI is added.

5. Method according to any one of the above claims, wherein it comprises dissimilar deposition conditions for at least two layers of the same element.

6. Method according to claim 5, wherein the second layer of element I is deposited at a higher electrode potential, as an absolute value, than the deposition potential of the first layer of element I.

7. Method according to any one of the above claims, wherein operation a2) comprises an increase to an alloying temperature of between 100 and 250°C for a period of between 5 and 120 minutes.

8. Method according to claim 7, wherein the increase in temperature is followed by a return to room temperature during a period of between 20 and 180 seconds in order to quench the I-III alloy before adding element VI.

9. Method according to claim 7, wherein the I-III alloy is maintained at alloying temperature before element VI is added.

10. Method according to any one of the above claims, wherein the addition of element VI comprises a second heat treatment in an atmosphere of element VI with a temperature increase to between 450 and 600°C, then maintaining it at this temperature for a period of between 30 and 600 seconds.

11. Method according to any one of the above claims, wherein the addition of element VI comprises:

    - a condensation of vapors containing element VI at a temperature of the I-III alloy of less than 100°C,
    - followed by a temperature increase to between 150 and 250°C maintained for 30 seconds to 15 minutes,
    - followed by a temperature increase to 450 to 550°C for 30 seconds to 15 minutes.

12. Method according to claim 11, wherein the element VI comprises selenium.

13. Method according to any one of the above claims, wherein the multilayer structure terminates at the surface in a layer of element I.

14. Method for producing a solar cell, wherein it comprises the method for producing a thin film of photovoltaic properties according to any one of claims 1 to 13.

In

Cu

In

Cu

Mo

FIG.1.

In

Cu

In

Cu

Mo

FIG.2.

In

Cu

In

Cu

In

Cu

In

Cu

In

Cu

} FIG.3.

Mo

Cu

In

Cu

In

Cu

} FIG.4.

Mo

Ga

In

Cu

Ga

In

Cu

Mo

FIG.5.

In

Cu

Ga

Cu

Mo

FIG.6.

**RÉFÉRENCES CITÉES DANS LA DESCRIPTION**

**Documents brevets cités dans la description**

- US 20070093006 A
- US 20070089782 A